(19) 

Europäisches
Patentamt
European
Patent Office
Office européen
des brevets

(11) **EP 1 760 877 A1**

(12) **EUROPEAN PATENT APPLICATION**

(43) Date of publication:
**07.03.2007 Bulletin 2007/10**

(51) Int Cl.:
***H03C 3/09*** *(2006.01)*

(21) Application number: **05447198.2**

(22) Date of filing: **02.09.2005**

(84) Designated Contracting States:
**AT BE BG CH CY CZ DE DK EE ES FI FR GB GR
HU IE IS IT LI LT LU LV MC NL PL PT RO SE SI
SK TR**
Designated Extension States:
**AL BA HR MK YU**

(71) Applicant: **Asic Ahead NV
3600 Genk (BE)**

(72) Inventor: **Op'T Eynde, Frank
3012 Leuven (BE)**

(74) Representative: **Van Malderen, Joëlle et al
pronovem - Office Van Malderen
Avenue Josse Goffin 158
1082 Bruxelles (BE)**

(54) **Reconfigurable signal modulator**

(57)    The present invention is related to a signal modulator circuit comprising
- mixing means (1) arranged for being fed with an in-phase and a quadrature component of an input signal and with an in-phase and a quadrature oscillator signal and for generating a mixed output signal,
- phase comparator circuit (4) arranged for being fed with a reference signal and with a comparator input signal and for generating a control signal $v_c(t)$,

- voltage controlled oscillator (6) arranged for being fed with the control signal $v_c(t)$ and for generating said in-phase and said quadrature oscillator signal,

characterised in that it further comprises a first switch (S1) arranged for switching between a first position wherein said comparator input signal is a version of the in-phase oscillator signal and a second position wherein the comparator input signal is a version of the mixed output signal.

Fig.3

EP 1 760 877 A1

**Description**

**Field of the invention**

The present invention relates to the field of signal generators.

**State of the art**

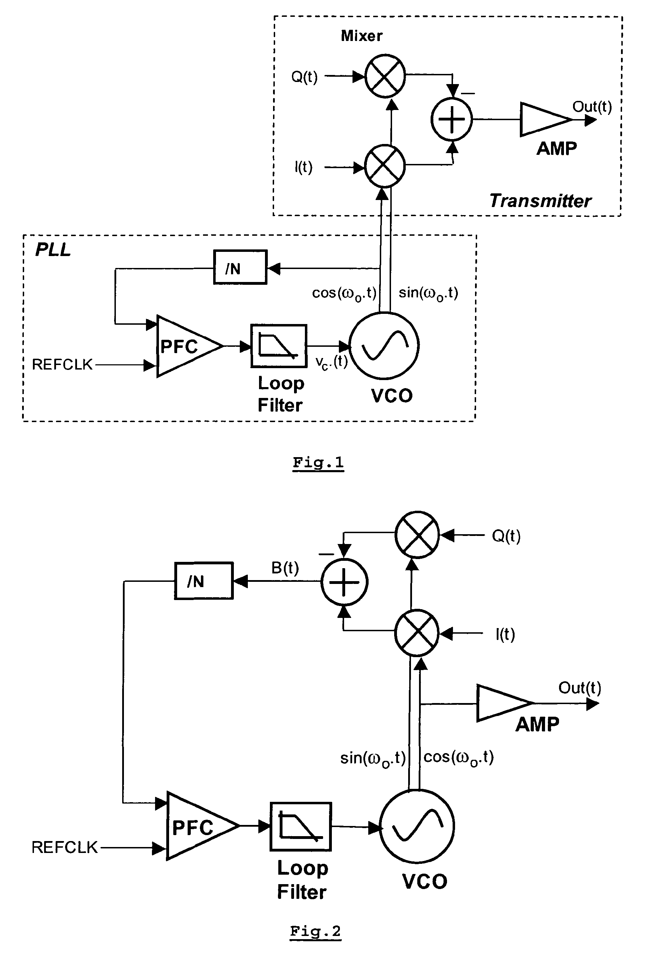

Most modern high-frequency signal generators contain a modulator to convert lower-frequency signals into a higher-frequency signal. A potential implementation of such a signal modulator means is depicted in Fig.1.
Assume that the signals *I(t)* and *Q(t)* in Fig.1 are two low-frequency signals :

$$I(t) = A(t) \cos(\phi(t)) \qquad \text{(eq.1a)}$$

$$Q(t) = A(t) \sin(\phi(t)) \qquad \text{(eq.1b)}$$

In these expressions, *A(t)* denotes the amplitude of the low-frequency signal and $\phi$*(t)* is the phase of the low-frequency signal. Both can be time dependent. In a practical example, the signals *I(t)* and *Q(t)* can be two sinusoidal low-frequency signals, given by

$$I(t) = A(t) \cdot \cos(\omega_{BB} \cdot t) \qquad \text{(eq.2a)}$$

$$Q(t) = A(t) \cdot \sin(\omega_{BB} \cdot t) \qquad \text{(eq.2b)}$$

Using mixing means, these two low-frequency signals are multiplied with two other signals (see Fig.1), and the results are then added:

$$Out(t) = I(t) \cdot \cos(\omega_o \cdot t) - Q(t) \cdot \sin(\omega_o \cdot t)$$

$$= A(t) \cdot \cos(\phi(t)) \cdot \cos(\omega_o \cdot t) - A(t) \cdot \sin(\phi(t)) \cdot \sin(\omega_o \cdot t)$$

$$= A(t) \cdot \cos(\omega_o \cdot t + \phi(t)) \qquad \text{(eq.3)}$$

This circuit is well-known in the literature. It is called a 'Single-Sideband Upconverter' or a 'Quadrature Modulator'. The signals $cos(\omega_0 t)$ and $sin(\omega_0 t)$ are generally denoted as local oscillator signals.
Equation (3) indicates that this principle allows producing an output signal ('Out' in Fig.1), with a frequency around the local oscillator frequency $\omega_o$, but with a phase $\phi$ and amplitude A that depend on the phase and amplitude of the low-frequency signals *I(t)* and *Q(t)*. If *I(t)* and *Q(t)* are amplitude-modulated (AM) signals, the output signal will also be an AM signal. If *I(t)* and *Q(t)* are frequency-modulated (FM) signals, the output signal is also a FM signal.
In many practical cases, the Local Oscillator signals are derived from a Phase-Locked-Loop (PLL). This is also depicted in Fig. 1. Such a PLL generally contains an oscillator ('VCO' in Fig.1), the frequency of which is controlled by a control signal $v_c(t)$ and a phase comparator ('PFC' in Fig.1). Some PLLs comprise a so-called 'phase-frequency comparator' circuit instead of a phase comparator and further also a loop filter and a charge pump. With respect to the present invention, this makes no difference. It may also contain a frequency divider means ('/N' in Fig.1). At the PLL input ('REFCLK' in Fig.1), a signal with a well-known reference frequency $\omega_{REF}$ is applied.

When locked, the PLL loop ensures that the phases of the two signals at the inputs of the PFC are equal. In some PLLs, this phase difference is 90 degrees, or another fixed value. Similar calculations can be made when the phase difference is equal to a value other than zero. Hence,

$$\omega_{REF}\, t = \frac{1}{N} \cdot \omega_o t \qquad \text{(eq. 4a)}$$

$$Out(t) = A(t) \cdot \cos(N.\omega_{REF} \cdot t + \phi(t)) \qquad \text{(eq.4b)}$$

A combination of a PLL and a Quadrature modulator thus allows creating an output signal with a precise frequency, derived from a reference frequency, and with an amplitude and phase that depend on the amplitude and phase of two lower-frequency signals. This principle is well-known in the prior art.
In Fig.2, an alternative approach is depicted. Here, the signal multiplying means are integrated inside the PLL loop. It can easily be seen that :

$$B(t) = I(t) \cdot \cos(\omega_o \cdot t) - Q(t) \cdot \sin(\omega_o \cdot t)$$

$$= A(t) \cdot \cos(\phi(t)) \cdot \cos(\omega_o \cdot t) - A(t) \cdot \sin(\phi(t)) \cdot \sin(\omega_o \cdot t)$$

$$= A(t) \cdot \cos(\omega_o \cdot t + \phi(t)) \qquad \text{(eq.5)}$$

Hence, the phase of signal B(t) in Fig.2 is equal to $\omega_o \cdot t + \phi(t)$. When locked, the PLL loop will force the phases of the two signals at the PFC inputs equal. This implies that:

$$\frac{\omega_o \cdot t + \phi(t)}{N} = \omega_{REF} \cdot t \qquad \text{(eq.6)}$$

and hence, the output signal 'Out(t)' is given by:

$$Out(t) = A_{VCO} \cdot \cos(\omega_o \cdot t) = A_{VCO} \cdot \cos(N.\omega_{REF} \cdot t - \phi(t)) \qquad \text{(eq.7)}$$

where $A_{VCO}$ is the VCO signal amplitude. This architecture is known in the literature as a polar modulator. It allows generating an output signal with a variable phase, but with constant amplitude $A_{vco}$. Some polar modulators contain additional circuits to vary the signal output amplitude, but this is not relevant in the present context. Although the polar modulator has the disadvantage of an invariable output amplitude, it offers other advantages such as better noise performance.
The benefits of combining quadrature and polar modulation were already recognised in patent application WO 03/101062 A1. This document discloses a dual modulation transmitter apparatus that allows switching between a signal path comprising a polar modulator and a signal path including a quadrature modulator. In that way the transmitter apparatus enjoys the best of both worlds, since it utilises quadrature or polar modulation in the most appropriate circumstances. However, in the presented solution there are still two separate modulators, one of which is not used, while the other modulator is in operation.

**Aims of the invention**

The present invention aims to provide an efficient implementation of a reconfigurable modulator arranged for operating either as a quadrature modulator or as a polar modulator, depending on the situation.

## Summary of the invention

The present invention relates to a signal modulator circuit comprising

- mixing means arranged for being fed with an in-phase and a quadrature component of an input signal and with an in-phase and a quadrature oscillator signal and for generating a mixed output signal,
- phase comparator circuit arranged for being fed with a reference signal and with a comparator input signal and for generating a control signal,
- voltage controlled oscillator arranged for being fed with the control signal and for generating an in-phase and a quadrature oscillator signal,

characterised in that it further comprises a first switch arranged for switching between a first position, wherein the comparator input signal is derived from the in-phase oscillator signal, and a second position, wherein the comparator input signal is derived from the mixer output signal.

In a preferred embodiment the signal modulator circuit further comprises a second switch arranged for switching between a first position wherein a signal modulator circuit output is fed with the mixer output signal and a second position wherein the signal modulator circuit output is fed with the in-phase oscillator signal.

Advantageously said first and second switch are arranged for switching simultaneously between their first position and their second position.

Preferably the comparator input signal is said in-phase oscillator signal when the first switch is in its first position and said mixer output signal when the first switch is in its second position.

In a preferred embodiment the signal modulator circuit output is further adapted for being applied to an amplifier circuit.

Advantageously the signal modulator circuit further comprises a loop filter between the phase comparator circuit and the voltage controlled oscillator.

When the switches are in the first position the signal modulator circuit output preferably generates a signal with variable amplitude. Alternatively, with the switches in the second position, the signal modulator circuit output generates a frequency-modulated or a phase-modulated signal.

In a further embodiment the signal modulator circuit further comprises a divider between the first switch and the phase comparator circuit

Preferably the control signal is determined by the phase and/or frequency relation between the reference signal and the comparator input signal.

Typically the reference signal is a clock signal.

## Short description of the drawings

Fig. 1 represents a block scheme of a quadrature modulator.

Fig. 2 represents a block scheme of a polar modulator.

Fig. 3 represents a block scheme of a signal modulator circuit according to the invention.

## Detailed description of the invention

For some applications, it is advantageous to have a signal modulator that offers either the flexibility of a quadrature modulator or the signal quality of a polar modulator. For example, consider a multi-mode signal generator that has to be able to generate either amplitude-modulated (AM) signals or frequency-modulated (FM) signals. For an AM output signal, a quadrature modulator can be used. On the other hand, creating FM signals with a polar modulator results in output signals with a better signal quality.

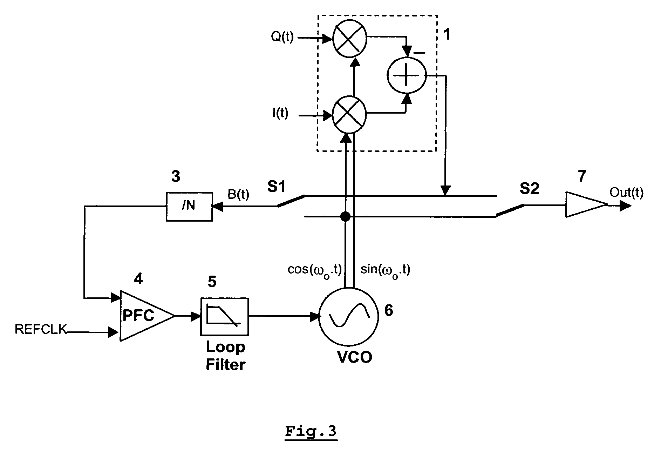

Fig.3 depicts a signal modulator according to the invention, that can be configured either a quadrature modulator of Fig.1 or as a polar modulator of Fig.2.

Indeed, a comparison of Fig.1 and Fig.2 shows that both circuits contain the same building blocks. The difference lies in the signal that is applied to the input of the digital divider ('/N') and in the signal that is applied to the input of the output amplifier ('AMP' in Fig.1 and Fig.2).

The signal modulator circuit according to the invention allows switching between the circuit of Fig.1 and that of Fig.2. The circuit of Fig.3 is identical to the circuit of Fig.1, except for the fact that it is provided with two switching means ('S1' and 'S2' in Fig.3).

When switch 'S1' is placed in position '1' the in-phase oscillator signal is used (directly or not) as the phase comparator input signal, while in position '2' the mixed output signal is fed to the phase comparator.

Further, when switch 'S2' is placed in position '1', the mixed output signal is applied to the modulator circuit output (optionally via an amplifier circuit), while in position '2' the in-phase oscillator signal is fed to the modulator circuit output. When both switching means are placed in position '1', the operation of the circuit of Fig.3 is identical to the Quadrature modulator of Fig.1. However, when both switching means are placed in position '2', the circuit of Fig.3 is identical to the polar modulator of Fig.2.

**Claims**

1.  Signal modulator circuit comprising

    - mixing means (1) arranged for being fed with an in-phase and a quadrature component of an input signal and with an in-phase and a quadrature oscillator signal and for generating a mixed output signal,
    - phase comparator circuit (4) arranged for being fed with a reference signal and with a comparator input signal and for generating a control signal $v_c(t)$,
    - voltage controlled oscillator (6) arranged for being fed with said control signal $v_c(t)$ and for generating said in-phase and said quadrature oscillator signal,

    **characterised in that** it further comprises a first switch (S1) arranged for switching between a first position wherein said comparator input signal is a version of said in-phase oscillator signal and a second position wherein said comparator input signal is a version of said mixed output signal.

2.  Signal modulator circuit as in claim 1, further comprising a second switch (S2) arranged for switching between a first position wherein a signal modulator circuit output is fed with said mixer output signal and a second position wherein said signal modulator circuit output is fed with said in-phase oscillator signal.

3.  Signal modulator circuit as in claim 2, wherein said first switch (S1) and said second switch (S2) are arranged for switching simultaneously between their first position and their second position.

4.  Signal modulator circuit as in any of claims 1 to 3, wherein said comparator input signal is said in-phase oscillator signal when said first switch (S1) is in said first position and said mixer output signal when said first switch (S1) is in said second position.

5.  Signal modulator circuit as in claim 2, 3 or 4, wherein said signal modulator circuit output is further arranged for being applied to an amplifier circuit (7) .

6.  Signal modulator circuit as in any of claims 1 to 5, further comprising a loop filter (5) between said phase comparator circuit (4) and said voltage controlled oscillator (6).

7.  Signal modulator circuit as in any of claims 2 to 6, with said first and second switches (S1,S2) in said first position and wherein said signal modulator circuit output generates a signal with variable amplitude.

8.  Signal modulator circuit as in any of claims 2 to 6, with said first and second switches (S1,S2) in said second position and wherein said signal modulator circuit output generates a frequency-modulated or a phase-modulated signal.

9.  Signal modulator circuit as in any of the previous claims, further comprising a divider (3) between said first switch (S1) and said phase comparator circuit (4).

10. Signal modulator circuit as in any of the previous claims, wherein said control signal $v_c(t)$ is determined by the phase and/or frequency relation between said reference signal and said comparator input signal.

11. Signal modulator circuit as in any of the previous claims, wherein said reference signal is a clock signal.

**Fig.1**

**Fig.2**

**Fig.3**

**European Patent Office**

**EUROPEAN SEARCH REPORT**

Application Number

EP 05 44 7198

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | EP 0 905 878 A (SIEMENS AG) 31 March 1999 (1999-03-31) * paragraph [0017] - paragraph [0036]; figure 2 * | 1-11 | H03C3/09 |
| A | US 6 028 493 A (C OLGAARD) 22 February 2000 (2000-02-22) * column 4, line 41 - column 6, line 10; figure 5 * | 1-11 | |
| A | US 6 091 303 A (P DENT) 18 July 2000 (2000-07-18) * column 3, line 50 - column 6, line 9; figure 1 * | 1-11 | |

TECHNICAL FIELDS
SEARCHED       (Int.Cl.7)

H03C

The present search report has been drawn up for all claims

| Place of search | Date of completion of the search | Examiner |
|---|---|---|
| The Hague | 21 October 2005 | Butler, N |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.....................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 05 44 7198

This annex lists the patent family members relating to the patent documents cited in the above-mentioned European search report.
The members are as contained in the European Patent Office EDP file on
The European Patent Office is in no way liable for these particulars which are merely given for the purpose of information.

21-10-2005

| Patent document cited in search report | | Publication date | Patent family member(s) | | Publication date |
|---|---|---|---|---|---|
| EP 0905878 | A | 31-03-1999 | DE | 19743275 A1 | 08-04-1999 |
| US 6028493 | A | 22-02-2000 | NONE | | |
| US 6091303 | A | 18-07-2000 | AT | 255296 T | 15-12-2003 |
| | | | AU | 4038400 A | 23-10-2000 |
| | | | CN | 1345482 A | 17-04-2002 |
| | | | DE | 60006792 D1 | 08-01-2004 |
| | | | EP | 1166447 A1 | 02-01-2002 |
| | | | JP | 2002541707 T | 03-12-2002 |
| | | | TR | 200102834 T2 | 22-04-2002 |
| | | | WO | 0060741 A1 | 12-10-2000 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 03101062 A1